# FASCICULE DE BREVET EUROPEEN

(11) **EP 2 870 654 B1**
(45) Date de publication et mention de la délivrance du brevet: **30.03.2016**
(21) Numéro de dépôt: 13737346.0
(22) Date de dépôt: 20.06.2013
(51) Int. Cl.: H01M 10/04, H01M 10/0525, H01M 6/40, H01M 10/0585, H01M 2/02

(54) **PROCÉDÉ D'ASSEMBLAGE ET D'ENCAPSULATION DE MICROBATTERIES AU LITHIUM ET MICROBATTERIES AINSI OBTENUES**
VERFAHREN ZUR MONTAGE UND VERKAPSELUNG VON LITHIUMMIKROBATTERIEN UND MIT DIESEM VERFAHREN HERGESTELLTE MIKROBATTERIEN
METHOD FOR ASSEMBLING AND ENCAPSULATING LITHIUM MICROBATTERIES AND MICROBATTERIES PRODUCED THEREBY

(30) Priorité: 06.07.2012 FR 1256530
(43) Date de publication de la demande: 13.05.2015
(73) Titulaire: Commissariat à l'Énergie Atomique et aux Énergies Alternatives, 75015 Paris (FR)
(72) Inventeur: BEDJAOUI, Messaoud, F-38340 Voreppe (FR); DELEPIERRE, Gabriel, F-38600 Fontaine (FR); POULET, Sylvain, F-38110 Saint Victor De Cessieu (FR)
(74) Mandataire: Cabinet Laurent & Charras
(86) Numéro de dépôt international: PCT/FR2013/051448
(87) Numéro de publication internationale: WO 2014/006296

(56) Documents cités:
- WO-A2-2009/073150
- US-A1- 2007 139 001
- US-A1- 2007 145 579
- US-A1- 2008 032 236
- US-A1- 2008 112 150
- US-A1- 2010 291 431
- US-B1- 6 982 132
- US-B2- 8 012 803
- FLÁVIA R. DE ALMEIDA ET AL: "Reactive ion etching of PECVD silicon nitride in SF6 plasma", JOURNAL OF NUCLEAR MATERIALS, vol. 200, no. 3, 1 mai 1993 (1993-05-01), pages 371-374, XP055053641, ISSN: 0022-3115, DOI: 10.1016/0022-3115(93)90311-L
- ELLIS MENG ET AL: "Plasma removal of Parylene C", JOURNAL OF MICROMECHANICS & MICROENGINEERING, INSTITUTE OF PHYSICS PUBLISHING, BRISTOL, GB, vol. 18, no. 4, 1 avril 2008 (2008-04-01), page 45004, XP020136803, ISSN: 0960-1317

## Description

### DOMAINE DE L'INVENTION

La présente invention concerne le domaine de l'encapsulation et de l'assemblage des microbatteries au lithium.

Plus particulièrement, l'invention se rapporte à un mode de connexion électrique d'un ensemble de microbatteries permettant d'offrir une encapsulation robuste et d'assurer une bonne compatibilité avec la technologie BEOL *« Back End of Line »* (technologie qui concerne les opérations d'interconnexion des composants), permettant ainsi leur connexion électrique avec d'autres éléments individuels (transistors, résistors, etc).

### ETAT DE LA TECHNIQUE

Dans le cadre de l'intégration des dispositifs pour la microélectronique, les microbatteries ont l'avantage de pouvoir s'adapter aux besoins croissants de ces applications en termes de tension et de puissance. Cette adaptation nécessite assez souvent des assemblages de microbatteries unitaires par des procédés de mise en série et/ou en parallèle.

Ainsi, un assemblage en série offre la possibilité de moduler la tension de sortie tandis qu'un assemblage en parallèle permet d'augmenter sensiblement la capacité totale.

Pour répondre à cette demande de nombreuses solutions d'assemblage ont été développées.

Par exemple, le document US 6,982,132 décrit un procédé d'empilement monolithique de microbatteries par dépôts successifs des couches actives (électrodes et électrolyte) sur le même substrat. Cependant, ce procédé n'offre pas de possibilité d'intégration de ces microbatteries avec des circuits externes en raison de l'absence de zones de reprise des contacts électriques.

Le document WO 2009/073150 décrit un procédé d'empilement et de collage de deux microbatteries unitaires positionnées l'une sur l'autre. La continuité électrique est assurée grâce à des microvias traversant l'un des substrats afin d'interconnecter les collecteurs de courant des deux microbatteries. Toutefois, la réalisation et le remplissage des microvias sans altérer les performances des microbatteries se révèlent être des processus très délicats. Ces difficultés deviennent insurmontables lorsque le nombre de microbatteries à empiler augmente.
De plus, il demeure essentiel de protéger efficacement les éléments réactifs à base de lithium contre les espèces oxydantes, notamment l'oxygène, l'azote, et la vapeur d'eau. Ainsi, la difficulté principale d'un assemblage « vertical » réside dans la réalisation de contacts électriques propres sans court-circuiter les microbatteries au lithium, tout en maintenant une robustesse mécaniques des flancs, ainsi qu'une résistance vis-à-vis de l'oxydation.
Pour résoudre ces problèmes, une étape d'encapsulation supplémentaire et techniquement lourde est parfois nécessaire afin d'assurer une protection robuste et complète de toutes les couches actives des espèces oxydantes.
Le document US 2007/0139001 décrit un procédé d'encapsulation d'une batterie avec un matériau électroniquement isolant. Chacune des couches constituant cette batterie présente une épaisseur égale à quelques micromètres ou à quelques dizaines de micromètres.
Le document US 2010/291431 décrit une microbatterie présentant un revêtement externe de protection. Cette microbatterie est fabriquée par formation d'une cellule unitaire sur un support, puis par dépôt d'un couvercle. Cette structure peut également être encapsulée par une protection multicouche.

### EXPOSE DE L'INVENTION

La présente invention offre une solution pour maitriser ces difficultés et protéger les couches lithiées des microbatteries unitaires vis-à-vis de l'air, et de manière générale de toute entité oxydante, tout en consolidant mécaniquement l'encapsulation du système final.
L'invention concerne tout d'abord un procédé d'encapsulation de microbatteries unitaires. Elle concerne également un procédé d'assemblage dit « vertical » de plusieurs microbatteries encapsulées, qui garantit une encapsulation finale robuste et complète, et sollicite des techniques d'interconnexion électrique ne faisant pas appel à la technologie contraignante des microvias. Les microbatteries ainsi encapsulées peuvent être de natures distinctes.
Dans le cadre de cette invention, on définit l'encapsulation comme une série d'étapes permettant une isolation électrique et étanche des microbatteries au lithium, tout en assurant la possibilité de pouvoir ultérieurement les connecter électriquement entre elles ou avec d'autres éléments microélectroniques.
Pour la mise en oeuvre des procédés de l'invention, un lot de microbatteries au lithium (ou une microbatterie unitaire) peut facilement être réalisé sur un substrat standard comme le silicium et selon les procédés décrit dans l'état de l'art.

Le substrat peut être rigide, notamment lorsqu'il est en silicium, verre, céramique, ou mica par exemple. Il peut également être souple, notamment lorsqu'il est en polyimide, PEN (polyéthylène naphtalate), ou PET (polyéthylène téréphthalate) par exemple.

Le substrat est avantageusement dépourvu de via, c'est-à-dire de trous traversants permettant d'atteindre les collecteurs de courant depuis la face inférieure du substrat (face opposée à celle sur laquelle est la microbatterie).

En général, le support (substrat) en silicium reçoit sur sa face supérieure les éléments actifs de la microbatterie, c'est-à-dire un système d'électrodes, positive et négative, et d'électrolyte, associées à des collecteurs de courant, reliés aux électrodes. Typiquement, l'électrolyte peut être supporté par un séparateur d'électrodes.

Les microbatteries au lithium peuvent ensuite être séparées les unes des autres, ou « singularisées », par des techniques de découpe comme le « *sawing* » (sciage) ou le *« scribing breaking »* (découpage/cassure) ou toute autre technique adaptée à la technologie des microbatteries.

Après singularisation des microbatteries, on obtient des puces avec des flancs latéraux de silicium sans protection électrique.

Ainsi, un premier aspect de l'invention concerne un procédé d'encapsulation d'une microbatterie au lithium sur un support, ladite microbatterie contenant des électrodes positive et négative, un électrolyte et des collecteurs de courant positif et négatif, comprenant les étapes suivantes :
- former une couche d'isolation électrique et/ou d'étanchéité sur au moins une partie des flancs latéraux et de la face comprenant les collecteurs de courant de la microbatterie ;
- rendre accessible les collecteurs de courant de la microbatterie ;
- former une couche métallique s'étendant depuis les collecteurs de courant jusqu'aux flancs latéraux de la microbatterie. Les collecteurs de courant n'étant pas électriquement connectés entre eux, la couche métallique est discontinue. En d'autres termes, il s'agit d'une couche métallique qui est formée sur chaque collecteur de courant, de manière à les rendre accessibles au niveau du flanc latéral correspondant de la microbatterie.

Selon un mode de réalisation particulier, la couche d'isolation électrique et/ou d'étanchéité est formée sur la totalité des flancs latéraux et de la face comprenant les collecteurs de courant de la microbatterie. Cette couche peut également recouvrir la face du substrat qui est opposée à la microbatterie.

En revanche, lorsque le substrat est électroniquement isolant, la couche d'isolation électrique et/ou d'étanchéité peut recouvrir qu'une partie des flancs latéraux et de la face comprenant les collecteurs de courant de la microbatterie.

Le rôle principal de cette encapsulation est donc d'assurer l'isolation électrique et l'étanchéité vis-à-vis des espèces susceptibles d'oxyder des parties actives de la microbatterie, tout en fournissant une accessibilité des collecteurs de courant, pour leur connexion électrique subséquente au sein d'un ensemble électronique.

La première étape de ce procédé d'encapsulation selon l'invention repose sur la mise en place d'un système assurant la double fonction d'isolation électrique et d'étanchéité sur la surface de la microbatterie qui le requiert.

Elle peut être mise en oeuvre soit par une seule couche bifonctionnelle, assurant en même temps l'isolation électrique et l'étanchéité, soit par un ensemble de deux couches, assurant respectivement la fonction d'isolation électrique et celle de barrière étanche.

De plus, certaines technologies de microbatteries au lithium rendent la présence de la couche d'isolation optionnelle. Ainsi, il est possible de déposer une seule couche qui assure la double fonction d'étanchéité et d'isolation électrique, dans le seul but d'améliorer les performances de la microbatterie.

Ainsi, et selon une première alternative, la couche d'isolation électrique assure également la fonction d'étanchéité, et comprend du SiN (nitrure de silicium) ou du Al₂O₃ (alumine).

Selon une deuxième alternative, le procédé d'encapsulation met en oeuvre un dépôt successif d'une couche d'isolation électrique et d'une couche d'étanchéité.

La première couche conduit à une isolation électrique de la microbatterie unitaire.

De manière avantageuse, la couche d'isolation électrique comprend un polymère chimiquement inerte par rapport aux électrodes, positive et négative, et l'électrolyte.

Avec le large panel des polymères accessibles commercialement, le choix du polymère est en général dicté par les paramètres qu'il faut privilégier au regard de l'application visée.

Ainsi, le choix d'un polymère adapté pour les microbatteries au lithium est essentiellement conditionné par une compatibilité physico-chimique avec les couches actives, c'est-à-dire l'électrode positive, l'électrolyte et l'électrode négative. Ainsi, le polymère ne doit pas réagir avec l'un de ces trois éléments de la microbatterie.

De préférence le polymère est compatible avec le procédé de gravure sèche de type *« Reactive Ion Etching* » ou RIE *(gravure ionique réactive).*

L'utilisation d'un polymère peut avantageusement répondre aux critères de flexibilité, défini comme le mouvement de charge/décharge d'une microbatterie, c'est à dire la migration du lithium entre les deux électrodes, et un mouvement de gonflement/dégonflement de la microbatterie. Cette flexibilité est nécessaire pour une encapsulation haute performante des microbatteries.

Le polymère de la couche d'isolation électrique peut donc jouer le rôle d'une couche tampon afin d'absorber les contraintes mécaniques induites par les expansions/contractions volumiques de la microbatterie.

Avantageusement, le polymère est choisi dans le groupe comprenant un époxy, le parylène, un acrylate, un silicone et leur mélange.

En raison du mode de dépôt, cette couche est généralement disposée sur les faces latérales de la microbatterie :
- soit en une seule étape, par évaporation, par « *dip coating* » (trempage-retrait), par *« Atomic Layer Deposition* » ou ALD (dépôt de couches atomiques) ;
- soit en deux étapes, comme par exemple via un dépôt par *« spin coating »* (enduction centrifuge), par « *Physical Vapor Deposition* » ou PVD (dépôt physique en phase vapeur), ou encore « *Plasma Enhanced Chemical Vapor Deposition* » ou PECVD (dépôt chimique en phase vapeur assisté par plasma).

De manière avantageuse, l'épaisseur de cette couche est choisie entre 1 et 5 micromètres et préférentiellement voisine de 2 micromètres, afin de rester compatible avec les étapes suivantes.

Dans un mode de réalisation préféré, ce type de dépôt est mis en oeuvre par évaporation thermique sur toute la surface de la microbatterie d'une couche de parylène.

La deuxième couche conduit à une étanchéité de la microbatterie unitaire.

Cette deuxième couche fait réellement office de barrière étanche de diffusion à la vapeur d'eau et est déposée sur l'ensemble constitué par la microbatterie au lithium revêtue de la couche d'isolation électrique, selon les procédés de l'état de l'art bien connus de l'homme du métier.

De préférence, la couche d'étanchéité comprend un élément diélectrique choisi dans le groupe comprenant l'oxynitrure de silicium, le nitrure de silicium, la silice, l'alumine et leur mélange.

De préférence, la couche d'étanchéité électrique présente une épaisseur comprise entre 10 et 500 nanomètres, de préférence entre 50 et 300 nanomètres. On observe en effet que si cette épaisseur est inférieure à 10 nanomètres, l'effet barrière requis n'est pas satisfait. Corollairement, si cette épaisseur est supérieure à 500 nanomètres, le stress mécanique des couches peut induire des effets inverses sur les propriétés barrière.

Selon le matériau choisi, cette couche est déposée par la technique de PECVD, par CVD ou par ALD, de sorte qu'elle couvre la totalité de la face supérieure de la microbatterie, comprenant les éléments actifs, ainsi que ses flancs latéraux.

Dans un mode de réalisation préféré, cette couche est réalisée par un dépôt d'un oxynitrure de silicium déposé par PECVD d'une épaisseur de l'ordre de 300 nanomètres.

D'une manière préférentielle, la couche d'isolation électrique et/ou d'étanchéité est apte à conférer à la microbatterie une valeur de résistivité au moins égale à 10¹² Ohm.cm, ce qui assure une bonne isolation des flancs.

De manière avantageuse, la couche d'isolation électrique et/ou d'étanchéité est apte à conférer à la microbatterie une valeur de barrière au moins égale à 10⁻⁴ g.m⁻².j⁻¹. Par « valeur de barrière » on désigne la grandeur WVTR pour l'expression anglo-saxonne *« Water Vapor Transmission Rate »* correspondant au taux de transmission de la vapeur d'eau, et caractérisant la propriété d'absorption ou de diffusion de l'eau dans les couches barrière.

Une telle grandeur peut être mesurée par des techniques comme le Test Calcium, le test Lithium ou par des perméamètres disponibles dans le commerce.

La deuxième étape du procédé d'encapsulation est destinée à permettre une ouverture partielle sur les contacts électriques émanant des électrodes, autrement dit permettre une accessibilité des collecteurs de courant.

De préférence, l'étape d'accessibilité des collecteurs de courant est réalisée par gravure sélective, avantageusement à travers un masque.

Dans un mode de réalisation particulièrement préféré, la gravure sélective comprend :
- une première étape de gravure sélective par un plasma de gaz fluoré ;
- une deuxième étape de gravure sélective par un plasma comprenant de l'oxygène.

En pratique, il faut une pression de travail de 1,33 Pa (soit 10mTorr), et une puissance de 80 Watts pendant 3 minutes pour réaliser une première gravure à l'aide d'un plasma SF₆ d'une couche de SiN d'une épaisseur de 300 nanomètres.

De manière avantageuse, la deuxième étape de gravure sélective est mise en oeuvre à l'aide d'un mélange oxygène O₂/gaz fluoré SF₆, dans un ratio O₂/SF₆ égal à 9:1.

Selon un autre mode de réalisation particulier, la deuxième étape de gravure sélective est mise en oeuvre à l'aide d'un plasma constitué d'oxygène O₂.

De manière pratique, il faut compter 15 minutes avec un plasma O₂ avec une pression de travail de 1.33 Pa (100 sccm) à 300 Watts pour réussir une gravure complète d'une couche parylène de 2 micromètres d'épaisseur.

Pour réaliser cette étape, le masque de gravure est disposé de manière à permettre l'accessibilité des seuls collecteurs de courant.

La troisième étape du procédé d'encapsulation consiste en une métallisation des collecteurs de courant et des flancs latéraux de la microbatterie.

Elle comprend le dépôt en une seule étape d'une couche métallique discontinue recouvrant de façon continue, de part et d'autre des éléments actifs de la microbatterie, le collecteur de courant et le flanc latéral adjacent.

De manière avantageuse, la couche métallique est obtenue par dépôt isotrope ou par dépôts de couches atomiques (ALD).

En pratique, cette étape contribue à la fabrication de contacts métalliques, et peut être réalisée par tout type de techniques de dépôt isotrope des couches minces comme le *« Physical Vapor Deposition* » ou PVD.

Elle est généralement obtenue par des techniques de localisation comme le masquage mécanique ou la photolithographie. Par exemple, une épaisseur moyenne de 200 nanomètres d'un film typique en Ti/Au réalisé en PVD par masquage mécanique peut garantir la fonctionnalité de continuité électrique.

De préférence, la couche métallique comprend au moins un élément choisi à titre indicatif et non limitatif dans le groupe comprenant le titane, le tungstène, l'or, l'aluminium, l'argent, le nickel, seuls ou en mélange. Cependant, tous les métaux avec les propriétés de résistivité et les propriétés barrière susceptibles d'être déposés en couche mince pourraient être mis en oeuvre.

De manière avantageuse, la couche métallique a une épaisseur comprise entre 100 et 500 nanomètres. Si cette épaisseur est inférieure à 100 nanomètres, on s'expose à un risque de discontinuité électronique. Si cette épaisseur est supérieure à 500 nanomètres, on risque le stress mécanique et on altère les propriétés barrière.

Avantageusement, la couche métallique est apte à conférer à la microbatterie une résistivité au moins égale à 10⁻¹ Ohm.cm.

D'un point de vue pratique, l'étape d'encapsulation peut être réalisée de manière groupée en disposant judicieusement les différentes microbatteries unitaires dans des équipements de dépôt.

Un deuxième aspect de l'invention concerne une microbatterie encapsulée obtenue par le procédé décrit ci-dessus.

Un troisième aspect de l'invention concerne un procédé d'assemblage vertical de microbatteries unitaires préalablement encapsulées. Cet assemblage comprend, entre les microbatteries, une couche d'isolation électrique et/ou d'étanchéité et une couche métallique. Ce procédé d'assemblage comprend successivement :
- une étape d'empilement et de fixation d'au moins deux microbatteries unitaires, préalablement encapsulées, empilées l'une sur l'autre ;
- la formation d'une couche métallique, apte à assurer le couplage électrique de chacune des couches métalliques de chacune des microbatteries unitaires encapsulées.

De manière avantageuse, le procédé d'assemblage est mis en oeuvre sur des microbatteries unitaires encapsulées par le procédé d'encapsulation décrit ci-dessus.

La première étape de ce procédé d'assemblage vertical comprend un empilement et une fixation des microbatteries unitaires encapsulées empilées. Il s'agit donc d'empiler au moins deux microbatteries l'une sur l'autre, en intercalant une couche de liant (fixation, colle) entre les microbatteries préalablement encapsulées.

Selon la nature de l'assemblage recherché, les microbatteries unitaires encapsulées sont positionnées l'une sur l'autre dans une configuration de mise en série ou de mise en parallèle. Par exemple en cas de mise en parallèle, les collecteurs de courant cathodique et anodique des microbatteries encapsulées sont respectivement alignés verticalement.

De même, un couplage judicieux des collecteurs de courant cathodique et anodique permet de réaliser des assemblages en série, en inter-changeant les reprises de contact.

Selon un mode préféré de réalisation, la fixation des microbatteries encapsulées est réalisée au moyen d'une colle non conductrice et/ou d'un film adhésif non conducteur.

Encore plus préférentiellement, le collage est réalisé par une colle comprenant un époxyde thermique.

De manière avantageuse, le durcissement de la colle est réalisé à une température inférieure à 150°C compatible avec un faible budget thermique. Cette température est donc inférieure à la température de fusion du lithium (180 °C)

En pratique, l'emploi de la colle H70S® (Epoxy Technology) durcie à 85°C est adapté pour le type d'assemblage décrit dans la présente invention.

Suivant cette technique, plusieurs microbatteries encapsulées peuvent être assemblées par une succession d'étapes de collage, en fonction des performances de puissance recherchées.

La deuxième étape de ce procédé d'assemblage vertical selon l'invention comprend une étape de métallisation des microbatteries unitaires encapsulées, précédemment empilées et fixées.

La connexion électrique des collecteurs de courant des différentes microbatteries encapsulées unitaires est obtenue en mettant en oeuvre astucieusement les mêmes procédés décrits dans la troisième étape du procédé d'encapsulation d'une microbatterie unitaire. Ainsi, le dépôt d'une couche métallique permet de recouvrir les couches métalliques préexistantes sur chacune des microbatteries unitaires.

La PVD présente l'avantage de disposer d'un dépôt à la fois sur les flancs latéraux et sur la face supérieure, en raison de l'isotropie de cette technique.

La mise en oeuvre de ce procédé d'assemblage offre donc l'avantage d'avoir un système de microbatteries hautement performant en puissance et complètement hermétique vis-à-vis des espèces oxydantes.

Un quatrième aspect de l'invention concerne les microbatteries encapsulées assemblées obtenues par le procédé d'assemblage vertical décrit ci-dessus, c'est-à-dire un empilement de microbatteries préalablement et individuellement encapsulées. Cet empilement présente, sur chacun de ses flancs latéraux, une couche métallique connectant les collecteurs de courant des électrodes de même signe. Par « individuellement encapsulées », on entend que les microbatteries sont encapsulées de manière unitaire. En d'autres termes, ce n'est pas l'empilement de microbatteries qui est encapsulé mais chacune des microbatteries. Elles sont avantageusement encapsulées selon le procédé d'encapsulation décrit ci-dessus, par lots de microbatteries sur un même substrat ou microbatterie par microbatterie.

Ainsi, les procédés d'encapsulation et d'assemblage vertical selon l'invention répondent à l'ensemble des exigences des microbatteries au lithium, à savoir :
- une encapsulation totale des flancs et de la face comprenant les éléments actifs ;
- une facilité de mise en oeuvre ;
- une compatibilité et une facilité de connexion avec les circuits externes.

### BREVE DESCRIPTION DES FIGURES

D'autres buts et aspects avantageux de l'invention ressortiront mieux à la lecture de la description détaillée qui suit, donnée à titre indicatif et nullement limitatif à l'appui des figures annexées, dans lesquelles :
La figure 1 représente une vue en section verticale d'un lot de microbatteries, agencées horizontalement de manière linéaire.
La figure 2 représente une vue en section verticale de microbatteries unitaires, c'est-à-dire dissociées du lot linéaire ; chacune contient sur un support approprié, un élément central et des collecteurs de courant latéraux.
La figure 3 représente une vue de dessus d'une microbatterie unitaire, faisant apparaitre un élément central, des collecteurs de courant latéraux sur un support.
La figure 4 représente une vue en section verticale d'une microbatterie unitaire, laquelle étant recouverte totalement sur chacune de ses faces par une couche d'isolation et/ou d'étanchéité.
La figure 5 représente une vue en section verticale d'une microbatterie unitaire ayant subie le dépôt d'une couche d'étanchéité sur la totalité de la face supérieure et des flancs latéraux.
La figure 6 représente une vue en section verticale d'une microbatterie unitaire ayant subie un gravage sélectif, de sorte à rendre accessibles les collecteurs de courant.
La figure 7 représente une vue en section verticale d'une microbatterie unitaire, laquelle est recouverte par une couche métallique sur la totalité des collecteurs de courant, une partie de la face supérieure et la totalité des flancs latéraux.
La figure 8 représente une vue de dessus d'une microbatterie, pour laquelle la couche d'étanchéité recouvre la totalité de la microbatterie, à l'exception des collecteurs de courant, et de la région s'étendant des collecteurs de courant aux flancs latéraux adjacents, qui sont recouverts par une couche métallique.
La figure 9 représente une vue en section verticale de deux microbatteries encapsulées, fixées verticalement l'une sur l'autre au moyen d'une colle.
La figure 10 représente une vue en section verticale de deux microbatteries fixées l'une sur l'autre après dépôt d'une couche métallique qui assure le couplage électrique des collecteurs de courant de chacune des microbatteries.

### DESCRIPTION DETAILLEE DE L'INVENTION

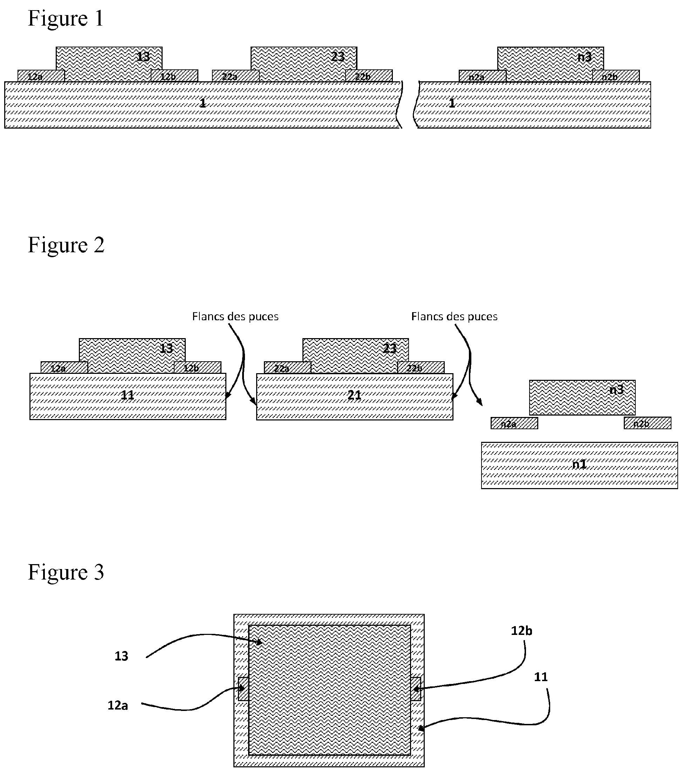

Un lot de microbatteries est réalisé sur un support de silicium (1). Sur la face supérieure de ce support sont mis en place les éléments actifs de la microbatterie au lithium, c'est à dires l'électrode positive, l'électrode négative et l'électrolyte, représentés sous la forme d'un élément unique (13, 23, n3) (Figure 1). Chacun des éléments est bordé de chaque côté par un collecteur de courant (12, 22, n2), dont un collecteur de courant anodique (12a, 22a, n2a) et un collecteur de courant cathodique (12b, 22b, n2b).

Le découpage par sciage en microbatteries unitaires libère des flancs latéraux (Figure 2). Une vue de dessus de la microbatterie illustre la position centrale des éléments actifs (13) au centre du support (1), et bordés de chaque côté, au niveau des flancs latéraux adjacents, par les collecteurs de courant (12a et 12b) (Figure 3).

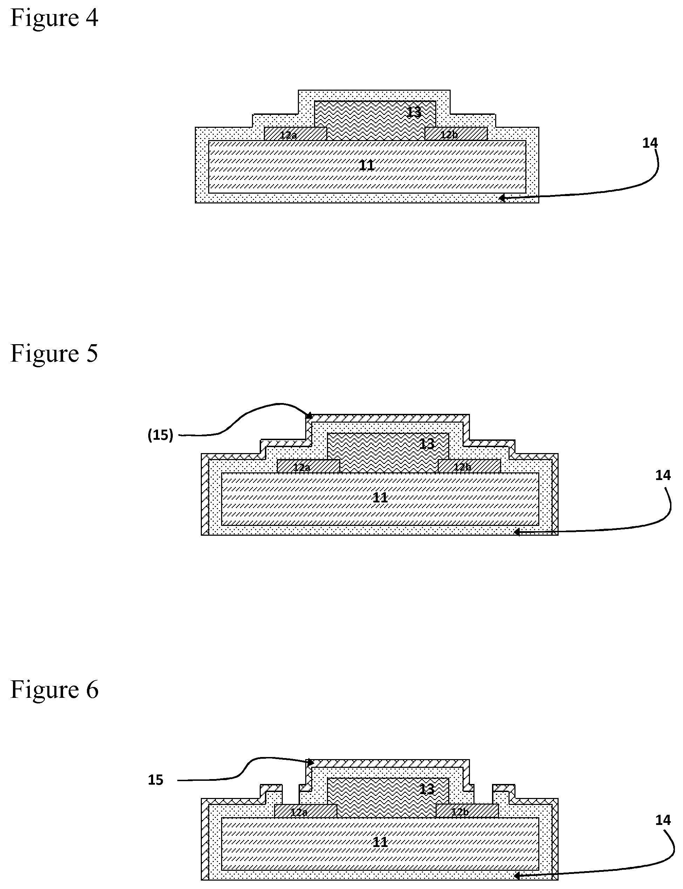

Le procédé d'encapsulation d'une microbatterie unitaire est maintenant décrit en relation avec les figures 4 à 8.

La première étape du procédé d'encapsulation comprend le dépôt d'une couche d'isolant électrique (14), par exemple sur chacune des faces de la microbatterie, protégeant ainsi les éléments actifs (13), les collecteurs de courant (12a et 12b) et les flancs latéraux adjacents (Figure 4).

La deuxième étape du procédé d'encapsulation comprend le dépôt d'une couche d'étanchéité (15), par exemple protégeant la face supérieure et les flancs latéraux de la microbatterie vis-à-vis des agressions provenant notamment de la vapeur d'eau et de l'oxygène (Figure 5).

Une étape de gravage (gravure) sélectif est mise en oeuvre, afin de rendre accessible les collecteurs de courant (12a et 12b), au niveau de la face supérieure de la microbatterie (Figure 6). Ainsi, à cet endroit il n'existe plus de couche d'isolation électrique, ni de couche d'étanchéité.

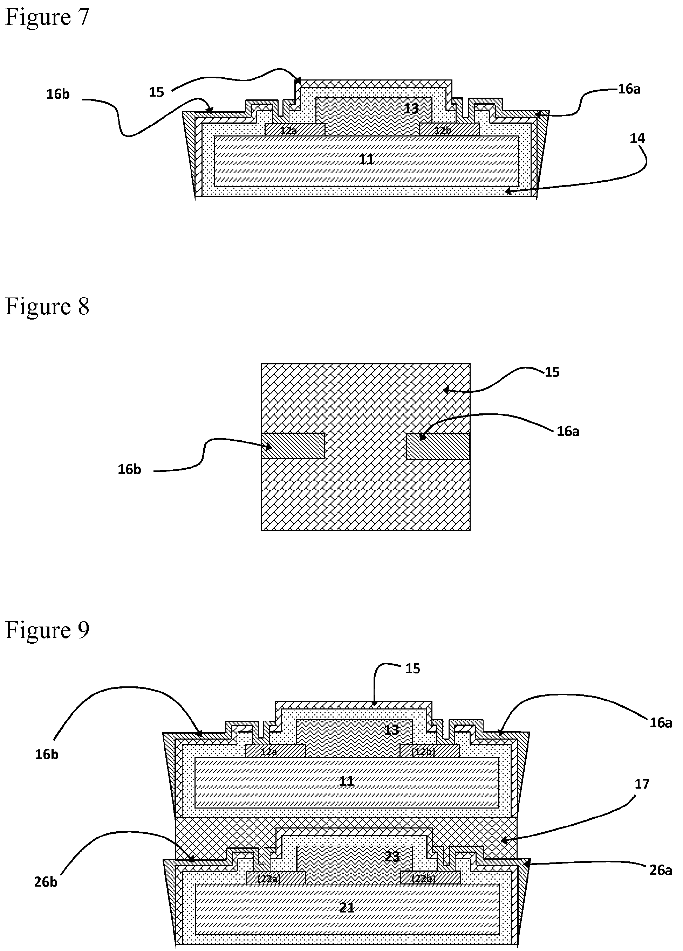

Le procédé d'encapsulation selon l'invention se termine par une étape de dépôt d'une couche métallique discontinue, sur une partie de la face supérieure et sur les deux flancs latéraux de la microbatterie, reliant ainsi électriquement chaque collecteur de courant (12a et 12b) avec le flanc latéral adjacent (Figure 7).

La figure 8 illustre la nature de la structure externe de la face supérieure de la microbatterie à la fin de cette étape. La face supérieure est enveloppée par une couche d'étanchéité (15), sauf au niveau de la région s'étendant des collecteurs de courant (12a et 12b) aux flancs latéraux de la microbatterie sur laquelle est déposée une couche métallique discontinue (16a et 16b).

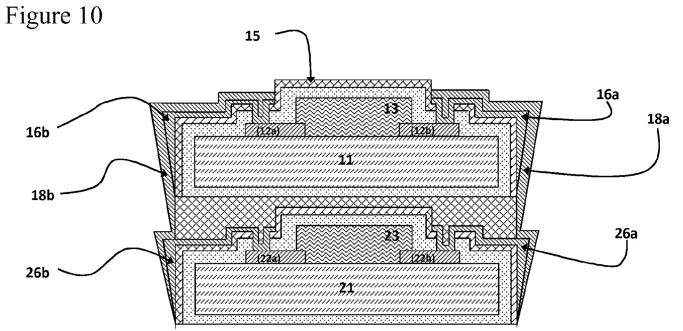

Le procédé d'empilement et d'encapsulation de deux microbatteries selon l'invention est maintenant décrit en relation avec les figures 9 et 10.

Deux microbatteries encapsulées sont empilées verticalement et rendues solidaires, ou fixées l'une sur l'autre par une couche de colle thermique, et par exemple non conductrice (17) (Figure 9). Les couches métalliques discontinues (16a et 26a) et (16b et 26b) de chaque côté, sur chacune des microbatteries ne sont pas en contact.

La deuxième étape de ce procédé consiste en un dépôt d'une couche métallique discontinue (18a et 18b) sur une partie de la face supérieure et les flancs latéraux respectifs définis par l'empilement. Cette couche métallique discontinue (18a et 18b) recouvre les couches métalliques (16a et 26a) et (16b e 26b) de chaque côté, sur chacune des microbatteries unitaires. Ainsi, à la fin de ce procédé d'assemblage vertical, les collecteurs de courant (12a et 22a), d'un côté, et (12b et 22b), de l'autre côté, sont désormais connectés les uns avec les autres.

Les différentes couches qui résultent de la mise en oeuvre de ces 2 procédés permettent :
- une bonne isolation électrique des éléments actifs de la microbatterie, évitant ainsi la survenue de court-circuit ;
- une bonne étanchéité de la microbatterie vis-à-vis des agressions résultant de la vapeur d'eau et des espèces oxydantes ;
- une connexion facile des collecteurs de courant à d'autres éléments électroniques, ce qui les rend compatibles avec la technologie « back end » ;
- une robustesse des flancs des microbatteries assemblées, permettant l'empilement d'un nombre conséquent de microbatteries unitaires.

## Revendications

1. Procédé d'assemblage vertical de microbatteries unitaires encapsulées, lesdites microbatteries encapsulées comprenant chacune des électrodes positive et négative, un électrolyte et des collecteurs de courant positif et négatif, ledit assemblage vertical contenant entre les microbatteries une couche d'isolation électrique et/ou d'étanchéité et une couche métallique, ledit procédé d'assemblage comprenant successivement :
- une étape d'empilement et de fixation d'au moins deux microbatteries unitaires (13, 23), préalablement encapsulées, empilées l'une sur l'autre ;
- la formation d'une couche métallique (18a, 18b), apte à assurer le couplage électrique de chacune des couches métalliques (16a, 16b ; 26a, 26b) de chacune des microbatteries unitaires encapsulées ;
chacune des au moins deux microbatteries unitaires encapsulées ayant été préalablement préparées par :
formation d'au moins une couche d'isolation électrique (14) et/ou d'étanchéité (15) sur au moins une partie des flancs latéraux et de la face comprenant les collecteurs de courant (12a, 12b; 22a, 22b) d'une microbatterie comprenant des électrodes positive et négative, un électrolyte et des collecteurs de courant positif et négatif ;
rendre accessible les collecteurs de courant (12a, 12b; 22a, 22b) de ladite microbatterie ;
formation d'une couche métallique (16a, 16b ; 26a, 26b) s'étendant depuis les collecteurs de courant (12a, 12b; 22a, 22b) jusqu'aux flancs latéraux de ladite microbatterie.

2. Procédé d'assemblage vertical de microbatteries unitaires encapsulées selon la revendication 1, ***caractérisé* en ce que** la fixation des microbatteries unitaires encapsulées est réalisée au moyen d'une colle non conductrice et/ou d'un film adhésif non conducteur, interposé entre deux microbatteries consécutives de l'empilement.

3. Procédé d'assemblage vertical de microbatteries unitaires encapsulées selon la revendication 2, ***caractérisé* en ce que** le collage est réalisé par une colle comprenant un époxyde thermique.

4. Procédé d'assemblage vertical de microbatteries unitaires encapsulées selon la revendication 1, ***caractérisé* en ce que** la la couche d'isolation électrique et d'étanchéité est réalisée par le dépôt successif d'une couche d'isolation électrique (14) et d'une couche d'étanchéité (15).

5. Procédé d'assemblage vertical de microbatteries unitaires encapsulées selon la revendication 1, ***caractérisé* en ce que** la couche d'isolation électrique (14) comprend un polymère choisi dans le groupe comprenant un époxy, le parylène, un acrylate, un silicone et leur mélange.

6. Procédé d'assemblage vertical de microbatteries unitaires encapsulées selon la revendication 1, ***caractérisé* en ce que** la couche d'isolation électrique (14) présente une épaisseur comprise entre 1 et 5 micromètres.

7. Procédé d'assemblage vertical de microbatteries unitaires encapsulées selon la revendication 1, ***caractérisé* en ce que** la couche d'étanchéité comprend au moins un élément diélectrique choisi dans le groupe comprenant l'oxynitrure de silicium, le nitrure de silicium, la silice, l'alumine et leur mélange.

8. Procédé d'assemblage vertical de microbatteries unitaires encapsulées selon l'une des revendications 1 à 7, ***caractérisé* en ce que** la couche d'étanchéité (15) présente une épaisseur comprise entre 10 et 500 nanomètres.

9. Procédé d'assemblage vertical de microbatteries unitaires encapsulées selon la revendication 1, ***caractérisé* en ce que** l'étape d'accessibilité des collecteurs de courant est réalisée par gravure sélective.

10. Procédé d'assemblage vertical de microbatteries unitaires encapsulées selon la revendication 9, ***caractérisé* en ce que** la gravure sélective comprend :
- une première étape de gravure sélective par un plasma de gaz fluoré SF₆ :
- une deuxième étape de gravure sélective par un plasma comprenant de l'oxygène.

11. Procédé d'assemblage vertical de microbatteries unitaires encapsulées selon la revendication 1, ***caractérisé* en ce que** la couche métallique (18a, 18b) est obtenue par dépôt isotrope, ou par dépôt de couches atomiques.

12. Procédé d'assemblage vertical de microbatteries unitaires encapsulées selon la revendication 11, ***caractérisé* en ce que** la couche métallique (18a, 18b) comprend au moins un élément choisi dans le groupe comprenant le titane, le tungstène, l'or, l'argent, l'aluminium, le nickel, seuls ou en mélange.

13. Procédé d'assemblage vertical de microbatteries unitaires encapsulées selon l'une des revendications 11 ou 12, ***caractérisé* en ce que** la couche métallique (18a, 18b) présente une épaisseur comprise entre 100 et 500 nanomètres.

14. Empilement vertical de microbatteries individuellement encapsulées, susceptible d'être obtenu par le procédé selon l'une quelconque des revendications 1 à 13.

## Patentansprüche

1. Verfahren zur vertikalen Montage einzelner gekapselter Mikro-Batterien, umfassend jeweils positive und negative Elektroden, ein Elektrolyt und positive und negative Stromsammler, wobei die genannte vertikale Montage zwischen den Mikro-Batterien eine elektrische Isolier- und/oder Abdichtungsschicht sowie eine Metallschicht umfasst, wobei das Montageverfahren nacheinander aus:
- einem Schritt des Stapelns und der Befestigung von mindestens zwei, vorher gekapselten, Einzel-Mikro-Batterien (13, 23), übereinander;
- der Bildung einer Metallschicht (18a, 18b), die geeignet ist, die elektrische Kopplung jeder Metallschicht (16a, 16b ; 26a, 26b) jeder der gekapselten Einzel-Mikro-Batterien zu gewährleisten, besteht,
wobei jede der mindestens zwei gekapselten Einzel-Mikro-Batterien vorher durch:
. die Bildung mindestens einer elektrischen Isolierschicht (14) und/oder Abdichtungsschicht (15) auf mindestens einem Teil der Seitenflächen und der Seite, die die Stromsammler (12a, 12b; 22a, 22b) einer Mikro-Batterie mit positiven und negativen Elektroden, einem Elektrolyt und positiven und negativen Stromsammlern umfasst;
. die Zugänglichkeitsmachung der Stromsammler (12a, 12b; 22a, 22b) dieser Mikro-Batterie;
. die Bildung einer Metallschicht (16a, 16b ; 26a, 26b), die von den Stromsammlern (12a, 12b; 22a, 22b) bis zu den Seitenwänden dieser Mikro-Batterie reicht,
vorbereitet wurde.

2. Verfahren zur vertikalen Montage einzelner gekapselter Mikro-Batterien gemäß Anspruch 1, **dadurch gekennzeichnet, dass** die Befestigung der einzelnen gekapselten Mikro-Batterien mittels eines nicht leitenden Klebers und/oder einer nicht leitenden Klebefolie, die zwischen zwei über einander liegende Mikro-Batterien des Stapels geklebt wird, erfolgt.

3. Verfahren zur vertikalen Montage einzelner gekapselter Mikro-Batterien gemäß Anspruch 1, **dadurch gekennzeichnet, dass** die Verklebung mit einem Kleber erfolgt, der ein thermisches Epoxid enthält.

4. Verfahren zur vertikalen Montage einzelner gekapselter Mikro-Batterien gemäß Anspruch 1, **dadurch gekennzeichnet, dass** die elektrische Isolier- und Abdichtungsschicht durch sukzessive Ablagerung einer elektrischen Isolierschicht (14) und einer Abdichtungsschicht (15) ausgeführt wird.

5. Verfahren zur vertikalen Montage einzelner gekapselter Mikro-Batterien gemäß Anspruch 1, **dadurch gekennzeichnet, dass** die elektrische Isolierschicht (14) ein Polymer umfasst, das aus einer Gruppe bestehend aus einem Epoxid, einem Parylen, einem Acrylat, einem Silikon und ihren Mischungen ausgewählt wird.

6. Verfahren zur vertikalen Montage einzelner gekapselter Mikro-Batterien gemäß Anspruch 1, **dadurch gekennzeichnet, dass** die elektrische Isolierschicht (14) eine Dicke zwischen 1 und 5 Mikrometern aufweist,

7. Verfahren zur vertikalen Montage einzelner gekapselter Mikro-Batterien gemäß Anspruch 1, **dadurch gekennzeichnet, dass** die Abdichtungsschicht mindestens ein dielektrisches Element enthält, das aus einer Gruppe bestehend aus Siliziumoxinitrid, Siliziumnitrid, Silizium, Aluminiumoxid und ihre Mischungen ausgewählt wird.

8. Verfahren zur vertikalen Montage einzelner gekapselter Mikro-Batterien gemäß einem der Ansprüche 1 - 7, **dadurch gekennzeichnet, dass** die Abdichtungsschicht (15) eine Dicke zwischen 10 und 500 Nanometern aufweist.

9. Verfahren zur vertikalen Montage einzelner gekapselter Mikro-Batterien gemäß Anspruch 1, **dadurch gekennzeichnet, dass** der Schritt der Zugänglichkeit der Stromsammler durch selektive Gravur ausgeführt wird.

10. Verfahren zur vertikalen Montage einzelner gekapselter Mikro-Batterien gemäß Anspruch 9, **dadurch gekennzeichnet, dass** die selektive Gravur:
- einen ersten Schritt der selektiven Gravur durch ein Plasma eines fluorhaltigen Gases SF₆;
- einen zweiten Schritt der selektiven Gravur durch ein sauerstoffhaltiges Plasma Umfasst.

11. Verfahren zur vertikalen Montage einzelner gekapselter Mikro-Batterien gemäß Anspruch 1, **dadurch gekennzeichnet, dass** die Metallschicht (18a, 18b) durch isotrope Ablagerung oder Ablagerung von Atomschichten erfolgt.

12. Verfahren zur vertikalen Montage einzelner gekapselter Mikro-Batterien gemäß Anspruch 11, **dadurch gekennzeichnet, dass** die Metallschicht (18a, 18b) mindestens ein Element enthält, das aus einer Gruppe bestehend aus Titan, Wolfram, Gold, Silber, Aluminium, Nickel, alleine oder gemischt ausgewählt wird.

13. Verfahren zur vertikalen Montage einzelner gekapselter Mikro-Batterien gemäß einem der Ansprüche 11 oder 12, **dadurch gekennzeichnet, dass** die Metallschicht (18a, 18b) eine Dicke zwischen 100 und 500 Nanometern aufweist.

14. Vertikale Stapelung von einzeln gekapselten Mikro-Batterien, die durch das Verfahren nach einem beliebigen der vorstehenden Ansprüche 1 bis 13 erzielt wird.

## Claims

1. A method of vertically assembling encapsulated single microbatteries, said microbatteries comprising each positive and negative electrodes, an electrolyte and positive and negative current collectors, said vertical assembly containing between the microbatteries an electrical insulation and/or sealing layer and a metal layer, said assembly method successively comprising:
- a step of stacking and attaching at least two single microbatteries (13, 23), previously encapsulated, stacked on each other;
- the forming of a metal layer (18a, 18b), capable of ensuring the electrical coupling of each of the metal layers (16a, 16b ; 26a, 26b) of each of the encapsulated single microbatteries;
each of the at least two encapsulated single microbatteries having been previously prepared by:
▪ forming at least one electrical insulation (14) and/or sealing (15) layer over at least a portion of the lateral sides and of the surface comprising the current collectors (12a, 12b ; 22a, 22b) of a microbattery comprising positive and negative electrodes, an electrolyte, and positive and negative current collectors;
▪ making the current collectors (12a, 12b ; 22a, 22b) of said microbattery accessible;
▪ forming a metal layer (16a, 16b ; 26a, 26b) extending from the current collectors (12a, 12b ; 22a, 22b) to the lateral sides of said microbattery.

2. The method of vertically assembling encapsulated single microbatteries of claim 1, wherein the attaching of the encapsulated single microbatteries is performed by means of non-conductive glue and/or of a non-conductive adhesive film, interposed between two consecutive microbatteries of the stack.

3. The method of vertically assembling encapsulated single microbatteries of claim 2, wherein the gluing is performed with glue comprising a thermal epoxy.

4. The method of vertically assembling encapsulated single microbatteries of claim 1, wherein the electrical insulation and sealing layer is formed by the successive deposition of an electrical insulation layer (14) and of a sealing layer (15).

5. The method of vertically assembling encapsulated single microbatteries of claim 1, wherein the insulation layer (14) comprises a polymer selected from the group comprising an epoxy, parylene, an acrylate, a silicone, and the mixture thereof.

6. The method of vertically assembling encapsulated single microbatteries of claim 1, wherein the electrical insulation layer(14) has a thickness in the range from 1 to 5 micrometers.

7. The method of vertically assembling encapsulated single microbatteries of claim 1, wherein the sealing layer comprises at least one dielectric element selected from the group comprising silicon oxynitride, silicon nitride, silica, alumina, and the mixture thereof.

8. The method of vertically assembling encapsulated single microbatteries of any of claims 1 to 7, wherein the sealing layer (15) has a thickness in the range from 10 to 500 nanometers.

9. The method of vertically assembling encapsulated single microbatteries of claim 1, wherein the step of accessibility of the current collectors is carried out by selective etching.

10. The method of vertically assembling encapsulated single microbatteries of claim 9, wherein the selective etching comprises:
- a first step of selective etching with a fluorinated SF₆ gas plasma;
- a second step of selective etching by a plasma comprising oxygen.

11. The method of vertically assembling encapsulated single microbatteries of claim 1, wherein the metal layer (18a, 18b) is obtained by isotropic deposition, or by atomic layer deposition.

12. The method of vertically assembling encapsulated single microbatteries of claim 1, wherein the metal layer (18a, 18b) comprises at least one element selected from the group comprising titanium, tungsten, gold, silver, aluminum, nickel, alone or in a mixture.

13. The method of vertically assembling encapsulated single microbatteries of any of claims 11 or 12, wherein the metal layer (18a, 18b) has a thickness in the range from 100 to 500 nanometers.

14. A vertical stack of individually encapsulated microbatteries, capable of being obtained by the method of any of claims 1 to 13.
